# EUROPÄISCHE PATENTANMELDUNG

(11) **EP 0 580 050 A1**
(43) Veröffentlichungstag der Anmeldung: **26.01.1994**
(21) Anmeldenummer: 93111105.8
(22) Anmeldetag: 12.07.1993
(51) Int. Cl.: B32B 15/08, C23F 1/02, H01L 21/321

(54) **Verfahren zur Herstellung eines Polymer/Metall- oder Polymer/Halbleiter-Verbundes**

(30) Priorität: 21.07.1992 DE 4223887
(71) Anmelder: BASF Aktiengesellschaft, D-67063 Ludwigshafen (DE)
(72) Erfinder: Hoessel, Peter, Dr., D-6707 Schifferstadt (DE); Harth, Klaus, Dr., D-6719 Altleiningen (DE); Hoffmann, Gerhard, Dr., D-6701 Otterstdat (DE); Hibst, Hartmut, Dr., D-6905 Schriesheim (DE)

(57) **Zusammenfassung**

Die Erfindung betrifft ein Verfahren zur Herstellung eines Polymer/Metall- oder Polymer/Halbleiter-Verbundes mit einer Haftschicht zwischen Polymer und Metall bzw. zwischen Polymer und Halbleiter, wobei auf das Metall bzw. den Halbleiter eine Schicht aus mindestnes zwei unterschiedlichen chemischen Elementen durch deren Aufdampfen oder Kathodenzerstäubung aufgebracht wird, dann in einem Ätzprozeß mindestens ein chemisches Element dieser Schicht selektiv oder teilweise entfernt wird und darauf das Polymer appliziert wird.

Dieses Verfahren eignet sich zur Herstellung von Verbundbauteilen.

## Beschreibung

Die Erfindung betrifft ein Verfahren zur Herstellung eines Polymer/Metall- oder Polymer/Halbleiter-Verbundes mit einer Haftschicht zwischen Polymer und Metall bzw. zwischen Polymer und Halbleiter mit verbesserter Haftfestigkeit.

Polymere Materialien weisen aufgrund ihrer spezifischen Eigenschaften (z.B. geringes Gewicht, gute chemische Beständigkeit, hohe Schlagzähigkeit) große Bedeutung als Werkstoffe auf. Ihre hervorragende Verarbeitbarkeit durch Spritzguß, Gießen, Blasformen, Extrusion, Pressen etc. ermöglicht die Herstellung von Gegenständen und Formteilen mit beliebiger Geometrie in einfacher und präziser Weise. Allerdings können in vielen Anwendungsbereichen, insbesondere dort, wo besondere Anforderungen an die elektrischen oder magnetischen Eigenschaften, an die Wärmeleitfähigkeit oder an die mechanischen Eigenschaften eines Bauteils gestellt werde, die gewünschten Eigenschaftsprofile nur durch Polymer/Metall- oder Polymer/Halbleiter-Verbunde erfüllt werden. Aufgrund der zwischen Metallen und Polymeren stark unterschiedlichen Materialeigenschaften (z.B. Wärmeausdehnungskoeffizient, Elastizitätsmodul) und der geringen physikalischen und chemischen Bindungskräfte ist das Polymer/Metall-Interface eine prinzipielle Schwachstelle dieser Verbunde.

Es sind bereits verschiedene Verfahren zur Verbesserung der Haftfestigkeit in Polymer-Metall-Verbunden bekannt (vgl. z.B. E. Sacher, J.-J. Pireaux, S.P. Kowalczyk, Metallization of Polymers, ACS Symposium Series 440, 1990; K.L. Mittal, J.R. Susko, Metallized Plastics 1, Plenum), nämlich eine Aufrauhung des Polymers bzw. der Metallschicht durch mechanische Behandlung, eine Aufrauhung des Polymers bzw. der Metallschicht durch chemische Ätzverfahren (z.B. mit Chrom-Schwefelsäure), eine Aufrauhung des Polymers bzw. der Metallschicht durch physikalische Ätzverfahren (z.B. Plasmaätzen), das Einfügen von chemischen Haftgruppen (z.B. O-haltige funktionelle Gruppen) sowie die Abscheidung von Zwischenschichten (z.B. Sn, Cr etc.).

In der EP-A-152 634 wird ein Verfahren zur Herstellung von gedruckten Leiterplatten beschrieben, wobei metallische Zwischenschichten, insbesondere aus Cu, Ni, Ag, Zn, Al oder Legierungen dieser Elemente durch Aufdampfen oder stromlose/galvanische Abscheidung hergestellt und deren Oberflächen nachträglich aufgerauht werden.

In der EP-A-237 114 wird ein Verfahren zur Herstellung einer elektrisch leitenden Klebverbindung beschrieben, wobei die Haftvermittlungsschicht aus Übergangsmetallen der Reihe (I) Ti, V, Cr, Mn, Fe, Co, Ni, Cu und/oder (II) Zr, Nb, Mo, Te, Ru, Rh, Pd, Ag besteht, die durch elektrochemische Abscheidung oder durch Sputtern hergestellt wird.

Nachteile dieser bekannten Verfahren sind, daß die haftungsvermittelnde Wirkung begrenzt ist (nur geringe mechanische Verankerung) und daher die Einsatzgebiete der Polymer/Metall-Verbunde beschränkt sind.

Aufgabe der vorliegenden Erfindung war es daher, die Haftfestigkeit in Polymer/Metall-Verbunden für möglichst viele Anwendungsbereiche nachhaltig zu verbessern.

Es wurde überraschenderweise gefunden, daß die Haftfestigkeit in Polymer/Metall-Verbunden gegenüber dem Stand der Technik wesentlich verbessert werden kann, wenn in dem Verbund eine haftvermittelnde Zwischenschicht aus mindestens zwei verschiedenen chemischen Elementen eingesetzt wird und in einem anschließenden Ätzprozeß mindestens ein chemisches Element dieser Schicht selektiv oder teilweise entfernt wird. An der Oberfläche dieser Zwischenschicht können dabei Poren zur Verankerung des Polymers entstehen.

Gegenstand der vorliegenden Erfindung ist ein Verfahren zur Herstellung eines Polymer/Metall- oder Polymer/Halbleiter-Verbundes mit einer Haftschicht zwischen Polymer und Metall bzw. zwischen Polymer und Halbleiter, das dadurch gekennzeichnet ist, daß auf das Metall bzw. den Halbleiter eine Schicht aus mindestens zwei unterschiedlichen chemischen Elementen durch deren Aufdampfen oder Kathodenzerstäubung aufgebracht wird, dann in einem Ätzprozeß mindestens ein chemisches Element dieser Schicht selektiv oder teilweise entfernt wird und darauf das Polymer appliziert wird.

Die mindestens zwei unterschiedlichen chemischen Elementen werden vorzugsweise gleichzeitig durch Aufdampfen bzw. Kathodenzerstäubung auf das Metall bzw. den Halbleiter aufgebracht.

Bevorzugte Ausgestaltungen des erfindungsgemäßen Verfahrens bestehen darin, daß als unterschiedliche chemische Elemente zur Herstellung der Haftschicht mindestens eines aus der Gruppe Bor, Beryllium, Magnesium und Aluminium in Kombination mit mindestens einem Element aus der Gruppe Kohlenstoff, Silicium, Titan und Chrom eingesetzt werden, und daß die Haftschicht eine Dicke zwischen 0,1 nm und 10 µm aufweist.

Das Polymer kann insbesondere durch Pressen, Spritzguß, Extrusion, Kalandrieren oder Gießen appliziert werden.

Der Ätzprozeß kann chemisch mit Säuren, Laugen oder reaktiven Gasen oder mit Hilfe eines Plasmas durchgeführt werden.

Weitere Ausgestaltungen des erfindungsgemäßen Verfahrens bestehen auch darin, daß es sich bei dem Metall des Polymer/Metall-Verbundes um einen dimensionsstabilen festen metallischen Träger, einen flexiblen flächenhaften metallischen Träger, eine Metallfolie, einen draht- oder faserförmigen metallischen Träger oder um einen mit einer Metallschicht überzogenen Gegenstand handelt, oder daß die Polymeren in Form von Polymerfolien eingesetzt werden.

Gegenstand der vorliegenden Anmeldung ist auch die Verwendung eines gemäß dem erfindungsgemäßen Verfahren hergestellten Polymer/Metall-Verbundes als Verbundbauteil mit verbesserten mechanischen, dynamischen und/oder elektrischen Eigenschaften sowie die Verwendung eines derart hergestellten Polymer/Metall- bzw. Polymer/Halbleiter-Verbundes zur Herstellung von Verbundbauteilen im Maschinenbau, in der Fahrzeugindustrie oder Elektroindustrie oder zur Herstellung von Druckplatten mit haftfester photoempfindlicher Schicht.

Ein wesentlicher Vorteil der nach dem erfindungsgemäßen Verfahren hergestellten Polymer/Metall-Verbunde ist die ausgeprägte mechanische Verankerung des Polymers an der Oberfläche der Zwischenschicht. Diese mechanische Wechselwirkung unterstützt die in der Regel schwache chemische Wechselwirkung zwischen Polymer und Metall bzw. Polymer und Zwischenschicht und gewährleistet eine wesentliche Verbesserung der mechanischen Eigenschaften des Verbundes.

Zur Herstellung des Polymer/Metall-Verbundes kann die haftvermittelnde Zwischenschicht durch physikalische Depositionsverfahren von mindestens zwei unterschiedlichen chemischen Elementen, z.B. durch deren Aufdampfen, Kathodenzerstäubung oder Lichtbogenbeschichtung, bevorzugt durch Kathodenzerstäubung, auf einem metallischen Träger abgeschieden und anschließend einer Ätzbehandlung unterzogen werden. Danach wird das Polymer mit den üblichen Verfahrensschritten, wie Spritzguß, Extrusion, Kalandrieren, Pressen oder Gießen aufgebracht.

Zur Herstellung der Schicht aus mindestens zwei unterschiedlichen chemischen Elementen sind verschiedene methodische Varianten des Kathodenzerstäubung, wie Magnetron-Sputtern, DC- bzw. RF-Sputtern, Bias-Sputtern oder reaktives Sputtern sowie deren Kombinationen geeignet. Beim Magnetron-Sputtern befindet sich das zu zerstäubende Target in einem äußeren Magnetfeld, welche das Plasma in den Bereich des Targets konzentriert und damit eine Erhöhung der Zerstäubungsrate bewirkt. Beim DC- bzw. RF-Sputtern erfolgt die Anregung des Zerstäubungsplasmas in an sich bekannter Weise durch DC- bzw. RF-Generatoren. Beim Bias-Sputtern wird der zu beschichtende Formkörper mit einer in der Regel negativen Vorspannung (Bias) belegt, welche während der Beschichtung zu einem intensiven Beschuß des Formkörpers mit Ionen führt.

Die Herstellung mehrkomponentiger metallischer Legierungen erfolgt dabei üblicherweise durch Einbringen eines geeigneten Targets in die Beschichtungsanlage und durch anschließendes Zerstäuben des Targets in einem Edelgasplasma, bevorzugt in Ar. Geeignete Targets sind entweder homogene Legierungsstargets, die in bekannter Weise durch Schmelzverfahrern bzw. durch pulvermetallurgische Methoden hergestellt werden, oder inhomogene Mosaiktargets, die durch Zusammenfügen kleinerer Teilstücke unterschiedlicher chemischer Zusammensetzung oder durch Auflegen bzw. Aufkleben von kleinen scheibenförmigen Materialstücken auf homogene Targets hergestellt werden. In alternativer Weise können metallische Legierungen dadurch hergestellt werden, daß zwei oder mehrere Targets unterschiedlicher Zusammensetzung gleichzeitig zerstäubt werden (simultanes Sputtern).

Das Ätzen der Zwischenschicht kann chemisch oder elektrochemisch mit organischen oder anorganischen Säuren, Oxidationsmitteln oder basischen Reagenzien durchgeführt werden. Bei der Verwendung von beispielsweise (Al-Si)-Schichten erfolgt die Ätzbehandlung in bevorzugter Weise mit Natronlauge. In alternativer Weise kann das Ätzen mit einem reaktiven Gas erfolgen. Ebenso kann daß der Ätzvorgang in einem Plasma erfolgen. Die Ätzbehandlung sollte so gestaltet werden, daß eine vollständige oder partielle selektive Entfernung von mindestens einem chemischen Element der haftvermittelnden Zwischenschicht in einem oberflächennahen Bereich erfolgt. Die hierdurch gebildeten Mikrohohlräume oder Mikrofehlstellen in der Zwischenschicht können dann als Haftanker für die mechanische Verzahnung des Polymers dienen.

Als Träger für die erfindungsgemäße Zwischenschicht kommen alle leitfähigen Materialien in Frage. Bevorzugt werden metallische Träger wie z.B. Stahl, Aluminium oder Kupfer.

Als Halbleiter zur Herstellung von Polymer/Halbleiter-Verbunden kommen alle festen, halbleitenden Materialien, beispielsweise Silicium und Germanium in Frage.

Als Polymere kommen thermoplastische, duroplastische und duromere Polymere in Frage.
Bevorzugt sind thermoplastische Polymere, z. B. Polyester, wie Polyethylenterephthalat und Polybutylenterephthalat, Polyamide, Polysulfone, Polyethersulfone, Polycarbonate, Polyether, Polyoxymethylene, Polyketone, Poly(aryl)etherketone, Polymethylmethacrylat, Polyethylen, Polypropylen, Polyvinylchlorid, Polystyrol, Styrol/Butadien-Copolymere und Acrylnitril/Butadien/Styrol-Copolymere.

Bevorzugt sind auch Reaktionsharze oder Gießharze, welche erst in situ auf dem Träger auspolymerisieren, z. B. Methacrylat- oder Acrylatgießharze, Polyurethanharze oder Epoxidharze, sowie hochtemperaturbeständige Polymere, wie z. B. Polyesterimide, Polyimide, Polyamidimide, Polybenzimidazole und Polybenzoxazole.
Bevorzugt sind außerdem elektronisch selbstleitende Polymere, z. B. Polypyrrole, Polyaniline, Polythiophene, Polyparaphenylene, Polyphenylenvinylene, und Polyacetylene, welche gegebenenfalls als polymere Salze vorliegen oder dotiert sind, d. h. Überschußladungen besitzen.

In einer Ausgestaltungsform der vorliegenden Erfindung wird die haftvermittelnde Zwischenschicht auf einen festen, dimensionsstabilen metallischen Träger aufgebracht. Geeignete Träger sind beispielsweise Platten, Scheiben, Schalen, Hohlkörper, Würfel oder Körper mit anderen Geometrien. Anwendungsmöglichkeiten bieten sich insbesondere bei Verbundbauteilen mit verbesserten mechanischen Eigenschaften in Kraftfahrzeugen (z. B. Stoßfängersysteme, Frontpartien, Cardanwellen, Blattfedern, Sitzträgern, Saugrohren etc.), Flugzeugen (z. B. Leitwerke, Rumpfteile etc.) oder Schiffen, Verbundbauteilen mit verbesserten dynamischen Eigenschaften im Maschinenbau (z.B. Wellen, Zahnräder, Lager etc.), Verbundbauteilen mit verbesserten elektrischen bzw. mechanischen Eigenschften in der Elektrotechnik (z.B. Schalter, Batterien, Hochleistungstransistoren, Hochleistungsdioden, isolierte Stromschienen, Gehäuse, 3D-Leiterplatten etc.), Bauteilen in der Mikroelektronik (z.B. Bauelemente mit verbesserter Ummantelung, "Leadframes" mit verbesserter Haftung zu dem Chipgehäuse, mikroelektronische Bauelemente mit verbesserten Isolationsschichten und Zwischendielektrika, Steckverbinder etc.)

In einer weiteren Ausgestaltungsform der vorliegenden Erfindung wird die haftvermittelnde Zwischenschicht auf einen flexiblen, flächenhaften metallischen Träger aufgebracht. Geeignete Träger sind beispielsweise Stahlbleche mit einer Dicke im Bereich zwischen 0,05 mm und 5 mm. Die erfindungsgemäßen Polymer/Metall-Verbunde können dabei Anwendung finden als Druckplatten mit haftfester photoempfindlicher Schicht, Stahlbänder mit haftfester Korrosionsschutzbeschichtung, Lackbeschichtung, Dispersionsbeschichtung, Bedruckung bzw. Klebschicht.

Gemäß einer weiteren Ausgestaltungsform der vorliegenden Erfindung kann die haftvermittelnde Zwischenschicht in einem Laminat aus mindestens einer dünnen Polymerfolie bzw. Polymerschicht und mindestens einer dünnen Metallfolie bzw. Metallschicht eingesetzt werden. Die Dicke der Polymerfolie bzw. Polymerschicht kann dabei im Bereich zwischen 10 nm und 200 µm liegen. Die Dicke der Metallfolie oder Metallschicht kann im Bereich zwischen 1 nm und 200 µm liegen. Ein derartiges Laminat kann Verwendung finden als Informationsspeichermedium (z.B. Magnetband), Dünnschicht-Kondensator, Multilagen-Leiterplatte, Abschirmfolie, Diebstahlsicherung, Halbzeug für die Herstellung hochpermeabler magnetischer Bauteile (z.B. Kerne von Elektromagneten), Transfermetallisierungsfolie, Klebefolie mit guter elektrischer Leitfähigkeit bzw. guter Wärmeleitfähigkeit, bzw. als Verpackungsfolie mit guter Permeationssperrwirkung.

In einer weiteren Ausgestaltungsform der vorliegenden Erfindung kann die haftvermittelnde Zwischenschicht auf einen draht- oder faserförmigen metallischen Träger aufgebracht werden. Der Durchmesser des draht- oder faserförmigen Trägers kann im Bereich zwischen 0,1 µm und 10 cm liegen. Die entsprechenden Polymer/Metall-Verbunde können Verwendung finden als thermo- oder duroplastische Bauteile mit mechanischer Verstärkung und elektromagnetischer Abschirmwirkung (z.B. Gehäuse von Elektronikgeräten), Elastomere mit hoher mechanischer Stabilität (z.B. Stahlgürtelreifen), als Abschirmgewebe oder als Kabel mit haftfester isolierender Ummantelung.

Die im Beispiel genannten Teile und Prozente sind, soweit nicht anders angegeben, Gewichtsteile bzw. Gewichtsprozente.

### Beispiel

Ein poliertes Cu-Blech (Dicke 1 mm) wurde in eine handelsübliche Kathodenzerstäubungsanlage (z. B. der Firma Alcatel Typ SCM 850) eingebracht. Parallel zu dem Cu-Blech wurde in einem Abstand von 60 mm ein rundes Target mit der Zusammensetzung Al₇₀Si₃₀ eingesetzt. Die Vakuumkammer der Kathodenzerstäubungsanlage wurde auf ein Vakuum von 5 x 10⁻⁷ mbar evakuiert. Danach wurde Argon bis zu einem Druck von 9 x 10⁻³ mbar eingelassen. Bei einer Substrattemperatur von 200°C wurde das Cu-Blech durch Anlegen einer RF-Spannung zunächst einer 10-minütigen Sputterätzbehandlung unterzogen. Nach Abschluß der Sputterätzbehandlung wurde der Ar-Druck auf 5 x 10⁻³ mbar reduziert. Durch Anlegen einer DC-Spannung (Leistung 500 W) an das Al₇₀Si₃₀-Target wurde auf dem Cu-Blech eine Schicht der Dicke 3,5 µm abgeschieden. Die Substrattemperatur wurde dabei auf 200°C und der RF-Bias des Substrats auf -90 V gehalten.

Die erhaltene Schicht wurde anschließend durch einminütiges Eintauchen in eine 10 %ige wäßrige Natriumhydroxidlösung bei einer Temperatur von 25°C geätzt, in destilliertem Wasser gespült und getrocknet.

Ein Polymethylmethacrylat-Granulat wurde in einer Schichtdicke von 200 µm auf die geätzte Schicht durch Pressen aufgebracht. Die Polymethylmethacrylatschicht zeigte eine sehr hohe Schälfestigkeit. Im 180°-Schältest (Abziehen eines auf der Oberfläche der Polymethylmethacrylatschicht angebrachten Klebstreifens, z. B. Scotch-Tape der Fa. MMM, nach Knicken um 180°) wurde keine Ablösung der Polymerschicht von der Unterlage beobachtet. Im Gegensatz dazu zeigte eine Polymerschicht, die ohne Zwischenschicht auf die Unterlage aufgebracht wird, keinerlei Schälfestigkeit im Schälversuch.

## Patentansprüche

1. Verfahren zur Herstellung eines Polymer/Metall- oder Polymer/Halbleiter-Verbundes mit einer Haftschicht zwischen Polymer und Metall bzw. zwischen Polymer und Halbleiter, dadurch gekennzeichnet, daß auf das Metall bzw. den Halbleiter eine Schicht aus mindestens zwei unterschiedlichen chemischen Elementen durch deren Aufdampfen oder Kathodenzerstäubung aufgebracht wird, dann in einem Ätzprozeß mindestens ein chemisches Element dieser Schicht selektiv oder teilweise entfernt wird und darauf das Polymer appliziert wird.

2. Verfahren nach Anspruch 1, dadurch gekennzeichnet, daß als unterschiedliche chemische Elemente zur Herstellung der Haftschicht mindestens ein Element aus der Gruppe Bor, Beryllium, Magnesium und Aluminium in Kombination mit mindestens einem Element aus der Gruppe Kohlenstoff, Silicium, Titan und Chrom eingesetzt wird.

3. Verfahren nach Anspruch 1 oder 2, dadurch gekennzeichnet, daß die Haftschicht eine Dicke zwischen 0,1 nm und 10 µm aufweist.

4. Verfahren nach einem der vorhergehenden Ansprüche, dadurch gekennzeichnet, daß das Polymer durch Pressen, Spritzguß, Extrusion, Kalandrieren oder Gießen appliziert wird.

5. Verfahren nach einem der vorhergehenden Ansprüche, dadurch gekennzeichnet, daß der Ätzprozeß chemisch mit Säuren, Laugen oder reaktiven Gasen durchgeführt wird.

6. Verfahren nach einem der Ansprüche 1 bis 4, dadurch gekennzeichnet, daß der Ätzprozeß mit Hilfe eines Plasmas durchgeführt wird.

7. Verfahren nach einem der vorhergehenden Ansprüche, dadurch gekennzeichnet, daß es sich bei dem Metall des Polymer/Metall-Verbundes um einen dimensionsstabilen festen metallischen Träger, einen flexiblen flächenhaften metallischen Träger, eine Metallfolie, einen draht- oder faserförmigen metallischen Träger oder um einen mit einer Metallschicht überzogenen Gegenstand handelt.

8. Verfahren nach einem der vorhergehenden Ansprüche, dadurch gekennzeichnet, daß die Polymeren in Form von Polymerfolien eingesetzt werden.

9. Verwendung eines gemäß einem Verfahren nach einem der vorhergehenden Ansprüche hergestellten Polymer/Metall-Verbundes als Verbundbauteil mit verbesserten mechanischen, dynamischen und/oder elektrischen Eigenschaften.

10. Verwendung eines gemäß einem Verfahren nach einem der Ansprüche 1 bis 8 hergestellten Polymer/Metall- bzw. Polymer/Halbleiter-Verbundes zur Herstellung von Verbundbauteilen im Maschinenbau, in der Fahrzeugindustrie oder Elektroindustrie oder zur Herstellung von Druckplatten mit haftfester photoempfindlicher Schicht.
